(19)

Europäisches
Patentamt
European
Patent Office
Office européen
des brevets

(11)  **EP 4 530 718 A1**

(12)  **EUROPEAN PATENT APPLICATION**

(43) Date of publication:
**02.04.2025  Bulletin 2025/14**

(21) Application number: **23200829.2**

(22) Date of filing: **29.09.2023**

(51) International Patent Classification (IPC):
***G03F 7/00*** (2006.01)

(52) Cooperative Patent Classification (CPC):
**G03F 7/706839**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
• **VAN WYK, Pieter
  Veldhoven (NL)**
• **BUIJNSTERS, Frank, Jaco
  Veldhoven (NL)**

(74) Representative: **ASML Netherlands B.V.
Corporate Intellectual Property
P.O. Box 324
5500 AH Veldhoven (NL)**

(54)  **SPEEDING UP FORWARD ELECTROMAGNETIC COMPUTATIONS FOR SXR
RECONSTRUCTION**

(57)      A computer-implemented method is proposed for generating a spectral model representation of an electromagnetic element for use in determining an electromagnetic response to electromagnetic radiation interacting with the electromagnetic element. The spectral representation contains a two-dimensional array of elements corresponding to respective wave vectors, each of the wave vectors being defined by a (different) corresponding pair of wave numbers in two mutually transverse directions. The electromagnetic element is described geometrically as a plurality of slices stacked transverse to these directions, and each containing one or more polygons. The method comprises determining points along each of the polygon edges, a computes coefficient is computed based on an extent of the corresponding polygon edge in the transverse directions. Fourier components are generated in each of the transverse directions, for each of the wave vectors, by performing a Fast Fourier Transform, FFT, algorithm using the coefficients.

Fig. 10

EP 4 530 718 A1

**Description**

<u>FIELD</u>

The present invention relates to computer-implemented method of generating a spectral representation of an electromagnetic element (e.g., a grating) in an electromagnetic system for use in determining an electromagnetic response (e.g., reflection coefficients) to electromagnetic radiation interacting with the electromagnetic element. The invention further relates to a computer system arranged to perform the method and a computer program product comprising instructions for carrying out the same when implemented by a computer processor.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

As the feature size of fabricated products (e.g., a patterned wafer, or a grating) continues to decrease, metrology measurements continue to use progressively higher frequency electromagnetic radiation (e.g., soft x-rays, SXR) to properly resolve and characterize these products. SXRs, for example, can be used to resolve feature sizes on the nanoscale (i.e., those that have a dimension less than 100nm).

A known way to characterize an electromagnetic element (that is, an object which exhibits interactions with electromagnetic fields) is to compare a measured electromagnetic response (e.g., a scattered electric field) with an electromagnetic response predicted by a solver.

A solver is an algorithm for computing an electromagnetic response to electromagnetic radiation interacting with (e.g. passing through, reflected from and/or scattered by) the electromagnetic element. The solver inputs an emulated incident electromagnetic radiation and a geometrical representation of the electromagnetic element and outputs the electromagnetic response. The geometrical representation of the electromagnetic element can then be refined iteratively, until the predicted output from the solver matches with experiment within a predetermined error. This approach is explained in detail in, for example, Proc. SPIE 12496, Metrology, Inspection, and Process Control XXXVII (doi: 10.1117/12.2658495), which is incorporated herein by reference.

Broadly speaking, the process of characterizing an electromagnetic element can be grouped into two processing phases: (i) an initialization phase; and (ii) a solver phase.

In the initialization phase, geometrical and spectral representations of the electromagnetic element are constructed. The initialization phase involves slicing an electromagnetic element into a plurality of stacked slices, and characterizing the electromagnetic element according to the polygons that make up each of these slices.

The geometrical representation of an electromagnetic element may comprise an array containing polygon vertices, for each polygon in each of these slices.

The spectral representation of an electromagnetic element may comprise an array of Fourier coefficients, for each polygon in the slices, each Fourier coefficient corresponding to a respective wave vector.

In the solver phase, a Maxwell equation solver (e.g., COMPASS) is used to predict the effect of the electromagnetic element on the incident electromagnetic radiation.

In some examples, the solver phase involves solving a system of linear equations that describe the scattering effect of the electromagnetic element geometry on the incident electromagnetic radiation. These linear equations are solved iteratively. In general, the total iterations for convergence in the output scattered field increases with the magnitude of the scattering (i.e. the contrast between the scattered field and the incident field).

The total computation time for predicting an electromagnetic response therefore depends on the sum of the computation times for each of the initialization and solver phase. For higher frequency radiation, the initialization phase is impractically slow to compute (e.g., several 10s of hours), since the computational time required to evaluate an $N_x \times N_y$ array of Fourier coefficients, where $N_x$ and $N_y$ are the number of Fourier modes required in the $x$ and $y$ direction respectively, in the presence of a number $N_E$ of polygon edges directly using the analytical formula for a Fourier transform scales as $N_x \times N_y \times N_E$ which can be prohibitively large. At the same time, at these frequencies, the relative permittivity of many materials is close to unity, and so the contrast in the scattered electric field caused by the electromagnetic element is relatively small. This means that the solver phase is generally much faster to compute than the initialization phase as the number of iterations required can be very low (e.g., as low as 1 if the Born-approximation is applicable). Accordingly, at such frequencies, the initialization phase can present a bottleneck in processing.

An improved initialization phase for the solver is desirable.

SUMMARY

Aspects of the present disclosure provide a method, computer program product, and computer, as set out in the appended set of claims.

In general terms, the present disclosure aims to provide new and useful methods, systems and computer program products, which improve the initialization phase for solvers, in particular, for use in performing high fidelity optical metrology.

In more detail, the disclosure provides a computer-implemented method for generating a spectral model representation of an electromagnetic element (e.g., a grating) in an electromagnetic system (e.g., a lithography apparatus) for use in determining an electromagnetic response (e.g., reflection coefficients) to electromagnetic radiation (e.g., SXRs) interacting with the electromagnetic element.

The spectral representation contains a two-dimensional array of elements. Each "element" in the array corresponds to a respective wave vector, each of the wave vectors being defined by a (different) corresponding pair of wave numbers in each of a first and second mutually transverse direction (e.g., in the x and y directions). The electromagnetic element is described geometrically as a plurality of slices stacked transverse to these transverse directions (i.e., the z direction). Each slice is a cross section and defines one or more polygons (onto a background). In general, the slice is planar.

The method comprises determining a respective plurality of points for each polygon. These points represent points along each of the polygon edges. For each of these points, a first and second coefficient is computed based on an extent of the corresponding polygon edge in each of the first and second transverse directions, respectively (that is, the distance in each of the first and second directions though which the edge extends; or in other words, if the edge is decomposed into two components in the respective directions, the lengths of those two components).

The method further comprises generating Fourier components in each of the transverse directions, for each of the wave vectors, by performing a Fast Fourier Transform, FFT, algorithm based on the plurality of points, and for each of these points using the respective first and second coefficient, respectively. A FFT is a discrete Fourier transform algorithm transforming one domain (e.g. the spatial domain) into another domain (e.g. the spatial frequency domain) based on a factorization of a discrete Fourier transform matrix into a product of sparse factors (i.e. mostly zero). A FFT algorithm can be performed with a time cost which increases more slowly (e.g., as N log N) than quadratically with the number of points in the first domain, N, which are considered.

The spectral representation of the electromagnetic element is then generated based on the first and second Fourier components that are generated for each polygon.

Advantageously, with the proposed approach, the plurality of points and the first and second coefficients do not depend on wave vector. The same plurality of points, first and second coefficients are therefore used to evaluate the Fourier coefficients, for each polygon in the transverse slice. As a result, computation times of the proposed approach scale excellently with an increasing number of Fourier modes, and in particular more slowly than $N_x \times N_y \times N_E$.

Accurate model reconstructions of the electromagnetic elements at acceptable computational effort is therefore possible.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source
- Figure 8A and 8B schematically illustrate two transverse cross sections of an electromagnetic element;
- Figure 9 depicts a comparative example of computation times from the prior art (Equation 1) and the present disclosure (Equation 2);
- Figure 10 is a flow diagram of steps in a method of generating a spectral model representation;
- Figure 11 is a flow diagram of steps in a method of determining an electromagnetic response; and
- Figure 12 schematically depicts an example computer system in which embodiments can be implemented.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation (e.g., soft x-rays), electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

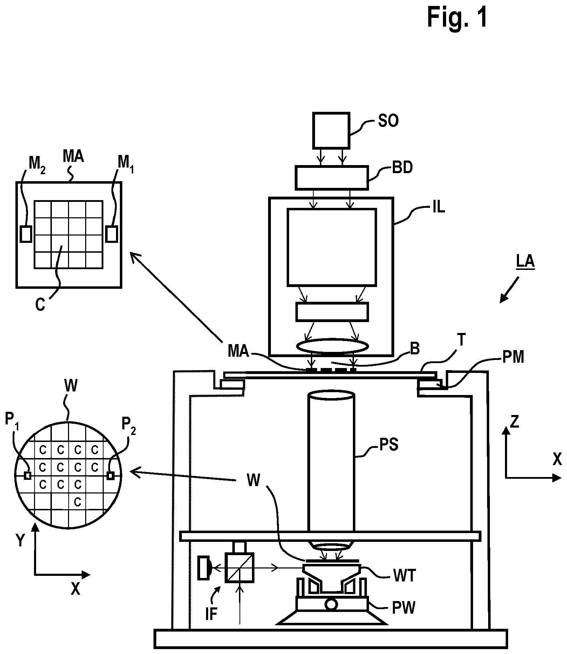

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

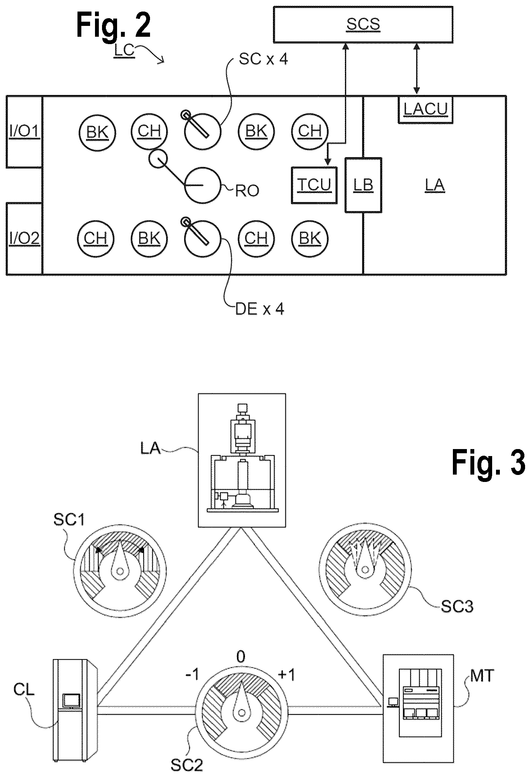

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

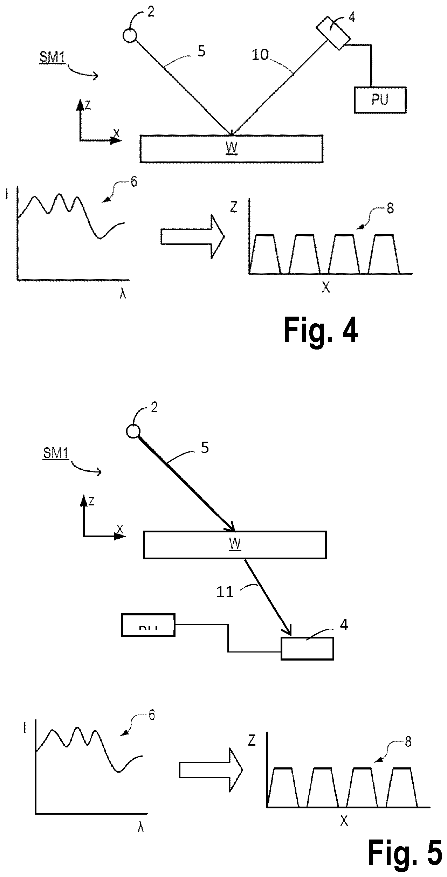

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges:

<0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1,

which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry,

goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

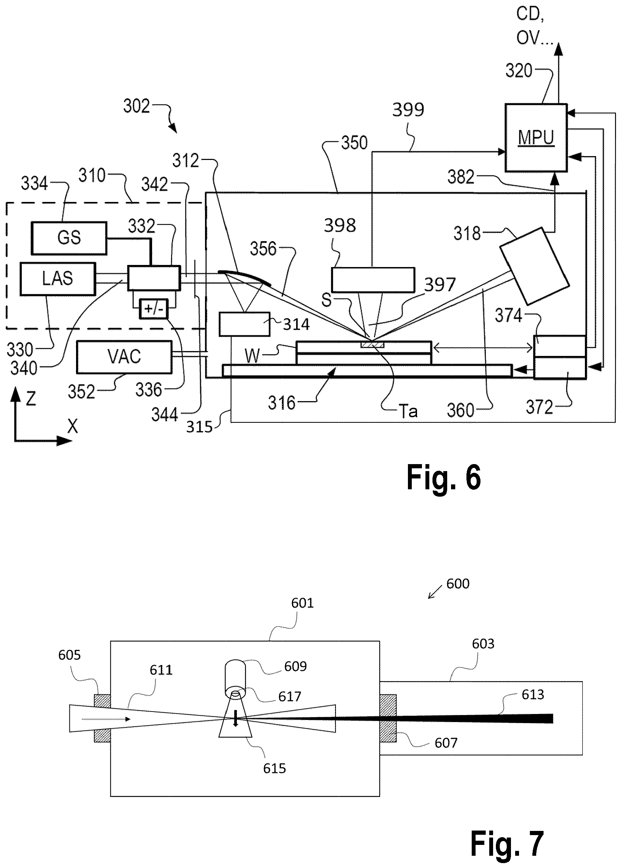

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to $10\mu m$, for example in the region of 1 $\mu m$ (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen (Oz), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

EP 4 530 718 A1

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

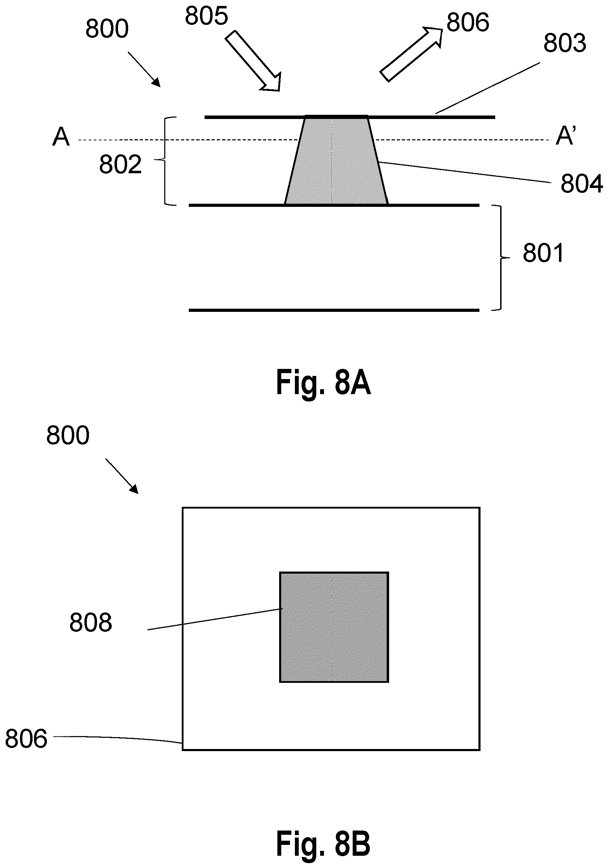

Figure 8A is a cross section 802 of an electromagnetic element 800 in a first plane. Figure 8B is a cross section 804 of the electromagnetic element 800 in a second plane, transverse to the first, along the dotted line AA', shown in Figure 8A. In a specific example, the electromagnetic element may be a product fabricated by a production process such as a lithographic process or an etching process, or an element which is used in lithographic process, such as a periodic grating.

In the example of Figures 8A and 8B, the electromagnetic element 800 includes a laminar substrate 801 (with its major surfaces parallel to the second plane) supporting a matrix layer 802 having an upper surface 803. A component 804 optionally having a trapezoidal cross-section in Figure 8A is embedded in the matrix layer 802.

The electromagnetic element 800 interacts with electromagnetic, EM, radiation. The interaction may allow for microscopic examination of the electromagnetic element 800. The interaction may include a scattering of, reflecting of, and/or passing through of EM radiation incident to the electromagnetic element. In the example shown in Figure 8A incident EM radiation 805 is partially reflected by the element 800 to produce reflected radiation 806. A fraction of the incident EM radiation may also pass through the electromagnetic element 800.

The first and second planes in which the cross-sections of Figures 8A and 8B are viewed may in some cases be based on a transmission direction of the incident electromagnetic radiation 805, as shown in Figure 5. More typically, as shown, the planes are chosen so that a region-of-interest in the electromagnetic element 800 varies relatively smoothly in a direction transverse to the second plane. For example, the component 804 varies relatively smoothly in the vertical direction of Fig. 8A, which is transverse to the second plane.

The electromagnetic element 800 can be represented by a plurality of stacked transverse cross sections or slices parallel to the second plane (i.e. transverse to the vertical direction in Figure 8A). One such slice is shown in Figure 8B. The geometry of the slice can be modelled as having a background component 806 (shown in white) and at least one component 808 (shown darker) referred to as a "polygon component" and having a polygonal shape in the plane. In the example shown, the polygon component 808 is a square, although the polygon can in general be any closed polygon, and the slice may contain any arrangement of closed polygons on a background. In this way, a geometrical representation of any arbitrary electromagnetic element can be generated. The electromagnetic element 800 can have more than two material constituents, with each constituent defining one or more corresponding polygon components in one or more of the slices.

The geometry of each polygon can be characterised by the coordinates of its vertices. Two transverse directions can be defined in the second plane, and denoted respectively by $x$ and $y$. In the example shown, the polygon component 808 can be represented by Cartesian coordinates $((x_1, y_1), (x_2, y_2), ..., (x_4, y_4))$ of its respective vertices. Other coordinate systems can also be used.

It will be understood by the skilled reader that the definition of the background and polygon component(s) for any given slice is, to an extent, arbitrary. That is, the coloured square in Figure 8B could, in theory, be regarded as the background component and the white frame-shaped area 806 could be regarded as being the polygon component. In practice, however, the polygon component 808 is generally defined as the component in the slice that is the simplest polygon shape or arrangement of polygons (i.e., the portion defining the fewest total edges). This ensures the computational expense of the initialization and solver phases is minimised.

As has already been noted, the spectral representation of an electromagnetic element may comprise a two-dimensional array of Fourier coefficients corresponding to respective different wave vectors, k, for each polygon in each slice of the element. The wave vectors may be defined by corresponding wave numbers in each of the x and y directions.

It can be shown that the Fourier coefficients, $f_k$, for any given wavevector k, of a closed polygon with number of (straight) edges, $N_E$, and vertices $(x_1, y_1), (x_2, y_2), .., (x_{N_E}, y_{N_E})$, can be evaluated according to Equation 1:

$$f_k = \frac{i}{2} \sum_{p=1}^{N_E} \left( \Delta y_p k_x^{-1} - \Delta x_p k_y^{-1} \right) e^{-ik \cdot \left( r_p + \frac{\tau_p L_p}{2} \right)} \operatorname{sinc} \left( \frac{k \cdot \tau_p L_p}{2\pi} \right)$$

where integer index p labels the vertices of the polygon (in a clockwise or counter-clockwise order around the periphery of the polygon); $\Delta y_p = y_{p+1} - y_p$ and $\Delta x_p = x_{p+1} - x_p$ represent the distance between vertices p and p+1 (or, in the case that $p$ is equal to $N_E$, the edge between vertex $N_E$ and vertex 1) in the y and x transverse directions, respectively (i.e. the extent of the edge between those vertices in the y and x directions respectively); $L_p$ is the length of the polygon edge between vertices p and p+1 (or, in the case that $p$ is equal to $N_E$ the edge between vertex $N_E$ and vertex 1), $\sqrt{\Delta \mathrm{x}_p{}^2 + \Delta \mathrm{y}_p{}^2}$ ; $r_p$ is a vector $\begin{pmatrix} x_p \\ y_p \end{pmatrix}$ which describes the position in the x-y plane of the $p$-th vertex of the polygon; and $\tau_p$ is a normalised vector $\frac{1}{L_p} \begin{pmatrix} \Delta x_p \\ \Delta y_p \end{pmatrix}$ which describes the direction of the polygon edge between vertices p and p+1 (or, in the case that $p$ is equal to $N_E$, the edge between vertex $N_E$ and vertex 1).

The time complexity in evaluating equation 1 is $O(N_E \times N_x \times N_y)$, where $N_x$ and $N_y$ is the number of Fourier modes in the transverse direction x and y, respectively. Each Fourier mode is a wave in the spatial domain, which oscillates sinusoidally in the x and y directions at a frequency given by its corresponding pair of static wave numbers $k_x$, $k_y$. A Discrete Fourier Transform transforms these Fourier modes into respective values (representing corresponding wave functions) in the spatial frequency domain.

For intricately shaped electromagnetic elements (i.e., those with a smallest feature size less than 10nm), this scaling imposes a practical upper limit in accuracy because either the number of Fourier modes or the number of polygon edges must be truncated to keep computation times within acceptable levels (e.g., less than several 10s of hours). The inherent error in the spectral representation of the electromagnetic element also propagates through to the predicted electromagnetic response made using the solver in the solver phase. To an extent, this can obfuscate the proper characterisation of the electromagnetic element, especially at higher frequencies (e.g., frequencies greater than 10,000 THz), since such frequencies often necessitate the modelling of nanoscale (i.e., < 10nm) print defects in the electromagnetic element. This is because the wavelength of electromagnetic radiation at these frequencies is less than 30nm (in free-space), which is sufficiently small to start probing nanoscale print defects. At these frequencies, the wavelength within the electromagnetic element is, to a first approximation, equal to the wavelength in free-space because the relative permittivity of the materials comprising the electromagnetic element will be, to a first approximation, equal to 1.

Proposed herein is an alternative approach for generating a spectral model representation of an electromagnetic element, which can be computed more efficiently than $O(N_E \times N_x \times N_y)$.

It can be demonstrated that the Fourier coefficients, $f_k$, for any given non-zero wavevector $k$, of a closed polygon with number of edges, $N_E$, represented by the vertices $(x_1, y_1)$, $(x_2, y_2)$,..., $(x_{N_E}, y_{N_E})$, can be evaluated according to Equation 2.

$$f_k = \frac{i}{2}\left[k_x^{-1} Y_k - k_y^{-1} X_k\right],$$

where $k_{x,y}$ are the wave numbers of the wave vector $k$ in the transverse x and y directions, respectively; and where

$$X_k = \sum_{p=1}^{N_E} \frac{\Delta x_p}{L_p} \int_0^{L_p} dl\, e^{-ik\cdot(r_p + \tau_p l)}$$

$$Y_k = \sum_{p=1}^{N_E} \frac{\Delta y_p}{L_p} \int_0^{L_p} dl\, e^{-ik\cdot(r_p + \tau_p l)}.$$

denote "first" and "second" Fourier components respectively.

The evaluation of $2N_E$ line integrals for each Fourier coefficient, $f_k$, is, however, computationally prohibitive in practice. To address this problem, this disclosure proposes approximating the line integrals using a numerical quadrature rule at a plurality of discrete points along each polygon edge. The plurality of discrete points forms a set.

More concretely, the line integrals can be approximated using a numerical quadrature rule (Equation 3):

$$\int_0^{L_p} dl\, e^{-ik\cdot(r_p + \tau_p l)} \simeq \sum_{q=1}^{N_Q} W_q\, e^{-ik\cdot(r_p + \tau_p l_q)},$$

Where $N_Q$ is the number of sample points for each polygon edge (for simplicity this is assumed to be the same for each edge, though in variations this is not the case); $\tau_p$ is a unit vector in the direction along the edge from the $p$-th vertex to the $p+1$-th vertex (or, in the case that $p$ is equal to $N_E$, the edge between vertex $N_E$ and vertex 1); $\{l_q\}$ for integer index $q=1,...$ $N_Q$, is a set of values between 0 and $L_p$ for each polygon edge, with each q value corresponding to a corresponding sampling point (also known as a quadrature point) at a distance $l_q$ from the *p-th vertex* at which the corresponding integrand from Equation 2 is to be numerically evaluated; and $\{W_q\}$ denotes a set of quadrature weights, each quadrature weight corresponding with a respective sampling point q. Note that for simplicity, the values $\{l_q\}$ are written without a subscript $p$, i.e. on the assumption they are the same for each edge. However, more generally, they may be different for different edges, in which case they would be written $\{l_{pq}\}$.

In a specific example, the numerical quadrature rule is a Gaussian-Legendre quadrature rule. The quadrature points and weights for this quadrature rule are known to literature and can be determined from a lookup table (i.e. without calculation, *per se)*. The skilled reader will understand, however, that the Gaussian quadrature rule relates to an integral over the interval [-1, 1] and so its quadrature points and weights require mapping the interval [-1, 1] onto the interval $[0, L_p]$ from equation 2 in order to calculate $\{l_q\}$ and $\{W_q\}$. In general, the quadrature weights and points can be scaled according to the length of the polygon edge to which the weight and points relate. For the Gaussian quadrature rule, a linear mapping of quadrature points and weights is applied: x' = $L_p$/2 (x+1) and W' = $L_p$W/2 is applied, i.e., if the quadrature points are x=-1 and 1, the mapped quadrature points, x', are 0 and $L_p$, respectively. Other quadrature rules and appropriate mapping rules can also be applied.

Substituting the numerical quadrature approximation for the line integral into Equation 2 gives the following expressions (Equation 4) for the first and second Fourier components, $\{X_k\}$ and $\{Yk\}$:

$$X_k \simeq \sum_{p=1}^{N_E} \sum_{q=1}^{N_Q} x_{pq}\, e^{-ik\cdot r_{pq}},$$

$$Y_{k} \simeq \sum_{p=1}^{N_{E}} \sum_{q=1}^{N_{Q}} y_{pq}\, e^{-i\mathbf{k}\cdot\mathbf{r}_{pq}}$$

where $\mathbf{r}_{pq} = \mathbf{r}_p + \tau_p l_q$, which represents a set of positions along each of the polygon edges, each position corresponding with a respective $l_q$ at which the integrand from Equation 2 is numerically evaluated; $x_{pq}$ form a set of coefficients ("first coefficients"), each first coefficient being equal to $\dfrac{\Delta x_p}{L_p} W_q$ ; and $y_{pq}$ forms another set of coefficients ("second coefficients", each second coefficient being equal to $\dfrac{\Delta y_p}{L_p} W_q$ . Each coefficient in the sets $x_{pq}$ and $y_{pq}$ represents the extent of the corresponding polygon edge, p, in the x and y directions, respectively, modified in magnitude by the respective quadrature weight $W_q$.

As shown in Equation 4, each of the first and second Fourier components $X_k$ or $Y_k$ is the 2-D discrete Fourier Transform, DFT, of the set of first coefficients $\{x_{pq}\}$ or the set of second coefficients $\{y_{pq}\}$, respectively, at sample positions $\mathbf{r}_{pq}$ along the polygon edges. This DFT can be evaluated efficiently using a Fast Fourier Transform, FFT, algorithm.

Advantageously, the sets of coefficients $\{x_{pq}\}$ and $\{y_{pq}\}$ and the sample positions $\{\mathbf{r}_{pq}\}$ over which the DFT is to be evaluated do not depend on wavevector, k. This means that $\{x_{pq}\}$, $\{y_{pq}\}$ and $\{\mathbf{r}_{pq}\}$ need only be computed once per polygon, and thereafter they can be used to evaluate any one of the Fourier coefficients. This can reduce the total computation time, if the number of Fourier coefficients is sufficiently large, for generating the spectral model representation of the electromagnetic element.

More specifically, the set of coefficients $\{x_{pq}\}$ and $\{y_{pq}\}$ at sample positions $\{\mathbf{r}_{pq}\}$ can be computed with a time-complexity of $O(N_Q \times N_E)$.

As has already been noted, some quadrature points are known to literature and can be determined from a lookup table. In some examples, sample positions $\{\mathbf{r}_{pq}\}$ are determined by mapping these known quadrature points for each polygon edge onto the respective polygon edge of length, $L_p$. For each polygon edge, the coefficients in the sets $x_{pq}$ and $y_{pq}$ are then computed based on the extent of that polygon edge in each of the x and y directions, respectively, modified in magnitude by the corresponding quadrature weight.

In other examples, the sample positions $r_{pq}$, for each polygon edge, are determined by defining the set $\{l_q\}$ for that polygon edge and calculating $\mathbf{r}_p + \tau_p l_q$ numerically. The quadrature weights corresponding to each element (i.e., quadrature point) in the set $l_q$ can then be computed according to the numerical quadrature rule. As above, the first and second coefficients in sets $\{x_{pq}\}$ and $\{y_{pq}\}$ can be computed, for each polygon edge, based on the extent of that polygon edge in each of the x and y directions, respectively, modified in magnitude by the corresponding quadrature weight.

The set $\{l_q\}$ for each polygon edge can be defined in a number of different ways. In one example, positions along the polygon edge are sampled uniformly or randomly. In that case, a Newton-Cotes quadrature rule (e.g., trapezoid or Simpson's rule) is applied to determine the quadrature weights. In an alternative example, the sample positions correspond with roots of an orthogonal polynomial, such as the Legendre polynomials, or Chebyshev polynomials. The quadrature weights are then the Gauss-Legendre quadrature weights or the Gauss-Chebyshev quadrature weights, respectively. The roots and weights can be obtained from a look-up table and then mapped onto the polygon edge, as explained above. In some examples, a Clenshaw-Curtis quadrature rule is applied. In such examples, the integrand (and its interval) is transformed to contain a cosine series, the integral of which is approximated using a discrete-cosine transform of the sample positions. In these examples, the sample positions and quadrature weights cannot, in general, be obtained from a "known" look up table, although bespoke look up tables could, in theory, be pre-calculated.

In some examples, the elements, $\{l_q\}$ are non-uniformly distributed along each polygon edge. In other examples, the elements, $l_q$, are uniformly distributed along each polygon edge. And, as noted above, they may be different for different edges, such that they are more properly denoted $\{l_{pq}\}$. In this case $l_{pg}$ would replace $l_q$ in Eqn. (3) and in the definition of $\mathbf{r}_{pq}$. In general, although not necessarily, the points, $\mathbf{r}_{pq}$, are non-uniformly distributed around the perimeter of the polygon and on the given transverse slice. The FFT algorithm, used to evaluate the 2D-DFT in equation 4, may, in general, therefore be a non-uniform, or non-equidistant one. However, it is possible for $r_{pq}$ to be uniformly distributed, and if so $l_{pq}$ is also uniformly distributed.

The time complexity in evaluating the 2D-DFT from equation 4, using a non-uniform FFT algorithm, is $O(N_k\log(N_k)+\log(N_Q N_E/\varepsilon))$, where $\varepsilon$ represents a predetermined accuracy of the NFFT and $N_k$ denotes the product of $N_x N_y$. The overall time complexity for evaluating equation 4 is, therefore, $O(N_Q N_E + N_k\log(N_k)+\log(N_Q N_E/\varepsilon))$. This is generally much less than $O(N_E N_x N_y)$ because in almost all examples $N_Q$, the number of values in the set $\{l_q\}$ over which it is required for $r_{pq}$ to be sampled to accurately evaluate Equation 4, is much less than the required number of Fourier coefficients ($N_k$). That is, in general, $O(N_Q N_E)$ is much less than $O(N_k N_E)$.

In many non-uniform FFT algorithms, the FFT is calculated by interpolating the non-uniformly distributed points for the FFT to uniformly distributed points and then performing an FFT on these uniformly distributed points. The predetermined accuracy of the NFFT can be set by controlling the number of non-uniformly distributed points used to sample each uniformly distributed sampling points. Increasing the number increases the accuracy, whereas decreasing the number decreases it.

In some examples, however, $O(N_Q N_E)$ is greater than $O(N_k N_E)$. This may arise in the case of polygons that have relatively long edges and large magnitudes of the wavevector **k**. In such examples, $O(N_Q N_E)$ can be made less than $O(N_k N_E)$ artificially by partitioning one or more of the polygon edges into shorter segments in order to decrease $N_Q$, and evaluating the Fourier coefficients for each of these segment separately. In particular, those polygon edges which have $N_k$, which is greater than $N_Q$, may be selected for this partitioning process. In general, at least within the SXR range, $O(N_Q N_E)$ is less than $O(N_k N_E)$ provided that the length of each polygon edge is less than around 1nm.

In some examples, the number of quadrature points required for each polygon edge and for a given numerical quadrature rule can be derived according to a predefined upper bound in error. That is, if the upper bound for the error is made comparatively low, a greater number of quadrature points will be required, whereas, if the upper bound is made lower, than fewer quadrature points are necessary. The number of quadrature points can then be tuned according to a desired accuracy, and the elements $N_Q$ of set $\{l_q\}$ can be determined accordingly. In a specific example, the Nyquist criterion is used to determine the required number of quadrature points based on the magnitude of the largest wave number, k. That is, the number of quadrature points is the product of (a) the length of the polygon edge and (b) at least twice the largest wave number.

The proposed approach is especially suitable for determining spectral model representations of electromagnetic elements whose transverse slices define polygons that have a number of edges which is greater than 50, more preferably greater than 250, even more preferably greater than 500, and which require many Fourier modes (e.g., > 25, >50, or >100) in each of the x and y directions to model accurately. This is because computation times with the proposed approach scale excellently ($N_k \log(N_k)$ cf $N_k$) with increasing number of Fourier modes, whereas conventional approaches do not. As such, the proposed approach is particularly advantageous when used to determine the electromagnetic response of an electromagnetic element to higher frequency electromagnetic radiation (e.g., SXRs), where even features on the nanoscale (i.e., <10nm) require modelling for accurate results.

In some examples, the number of points along any one of the polygon edges is less than 400, more preferably less than 150, even more preferably less than 50.

The spectral model representation of the electromagnetic element, which can be described geometrically as a plurality of slices stacked transverse to the x and y directions, can be obtained by determining the spectral representation of the one or more polygons defined by each transverse slice. An electromagnetic response can be determined by inputting this spectral model representation for the electromagnetic element into a Maxwell solver.

Example electromagnetic responses that can be calculated in this way include: a scattered or reflected electromagnetic field; an electromagnetic field due to radiation transmitted through the electromagnetic element; and near fields, which describe the state/behaviour of the scattered/reflected electromagnetic field.

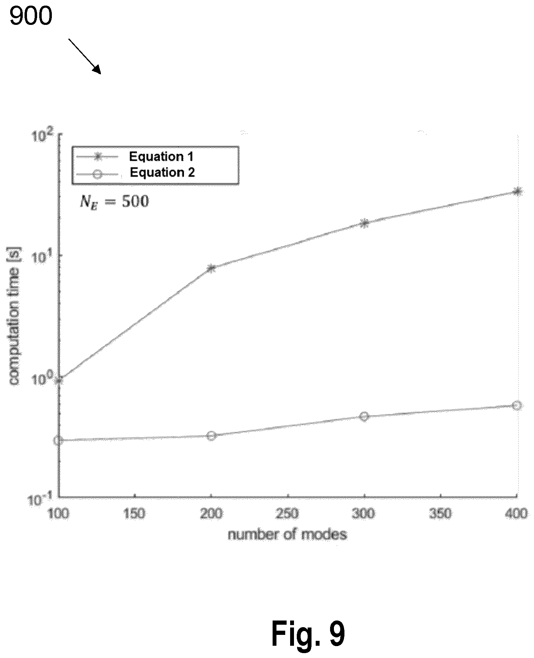

Figure 9 shows the total computation time required to evaluate the Fourier coefficients, for a regular polygon, having 500 edges with a fixed edge length of 0.1nm, for varying number of modes ($N_x$, $N_y$) in each of the x and y transverse directions, using Equations 1 and 2.

In the specific example shown, Equation 2 was calculated using the Gaussian-Legendre numerical quadrature. It will, however, be appreciated that the improvement in processing speed is not solely attributed to the use of this particular quadrature rule. Other quadrature rules will yield similar improvements.

A 11th gen Intel® Core(TM) i5-1145G7"2.60GHz CPU with 16GB of RAM was used to generate the results in Figure 9, although the skilled reader will, of course, understand that, other computers with different specifications, will lead to similar results, albeit with differing absolute values for the computation time.

Further results (not shown) confirm that these improvements in computation times do not affect numerical accuracy significantly.

As has already been noted, the proposed approach finds particular utility in EUV/SXR-based optical metrology, which are based on model reconstruction of a target object (i.e., the electromagnetic element).

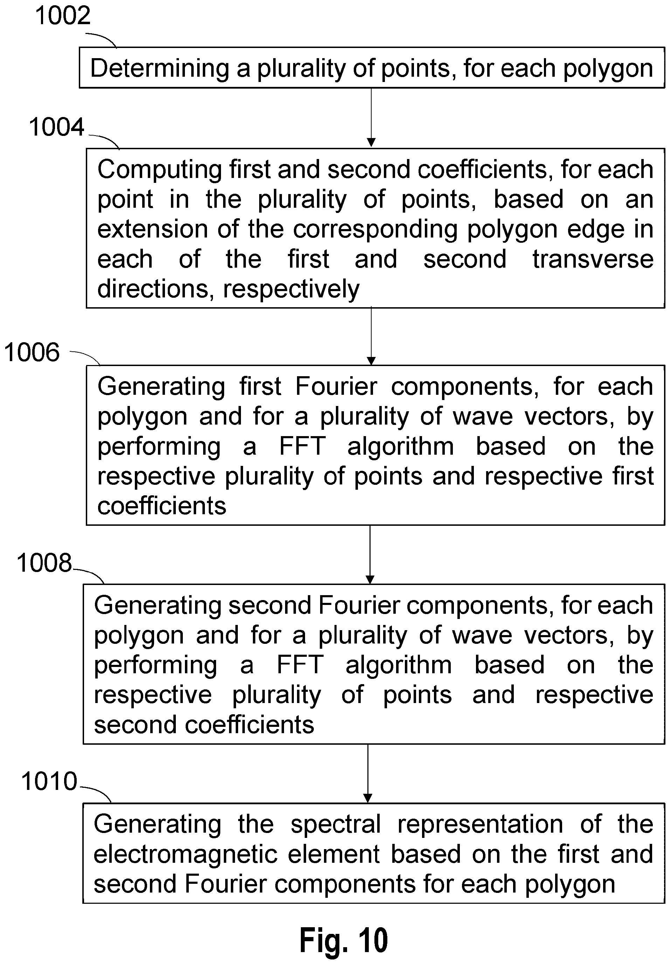

Figure 10 is a flow diagram, showing steps in a method of a generating a spectral representation of an electromagnetic element. The electromagnetic element can be described as a plurality of stacked transverse slices, each of which defines one or more polygons. The spectral representation of the electromagnetic element comprises an array of Fourier coefficients, for each polygon in the slices. Each array of Fourier coefficients has at least two dimensions, with Fourier coefficients that respectively correspond with different wave numbers, $k_x$, $k_y$.

In step 1002, a plurality of points is determined, for each polygon. The plurality points represent points along the edge of the polygon.

In step 1004, respective first and second coefficients, for each point in these plurality of points, are computed, based on an extent of the corresponding polygon edge in each of a first and second transverse direction (i.e., the x and y directions), respectively.

In step 1006, first Fourier components (i.e., $\{X_k\}$) are generated, for each polygon and for a plurality of wave vectors, by performing a FFT algorithm based on the respective plurality of points and the respective first coefficients. That is, for each point in the plurality of points, the corresponding first coefficient is used in the FFT.

In step 1008, second Fourier components (i.e., $\{Y_k\}$) are generated, for each polygon and for the plurality of wave vectors, by performing a FFT algorithm based on the respective plurality of points and the respective second coefficients. That is, for each point in the plurality of points, the corresponding first coefficient is used in the FFT.

In step 1010, the spectral representation of the electromagnetic element is generated based on the first and second Fourier components for each polygon, e.g. by Equation 2.

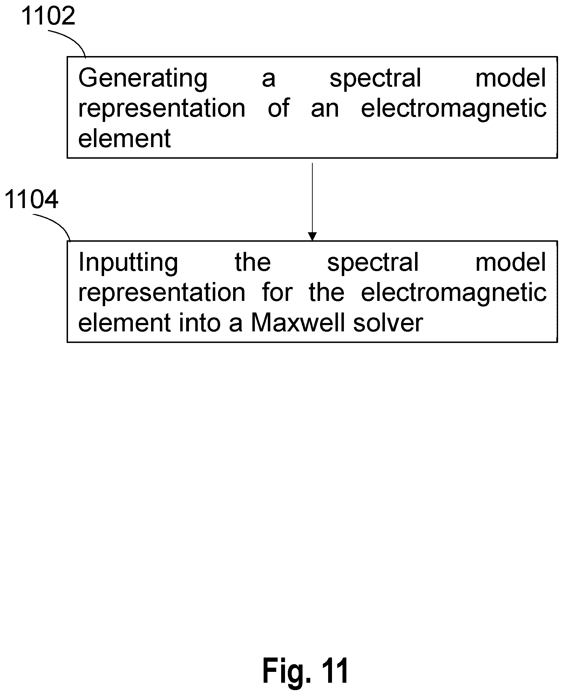

Figure 11 is a flow diagram, showing steps in a method of determining an electromagnetic response of an electromagnetic element to electromagnetic radiation.

In step 1102, a spectral model representation of the electromagnetic element is generated, for example, according to the method steps in Figure 10.

In step 1104, the spectral model representation is input into a Maxwell solver, along a representation of electromagnetic radiation incident on the electromagnetic element. The solver then evaluates the electromagnetic response according to these conditions. The incident electromagnetic radiation can be modelled as propagating in a direction perpendicular to the transverse slices of the electromagnetic element, or at an oblique angle thereto.

Optionally, there may be a further step of comparing the electromagnetic response obtained in step 1104 to experimentally measured data which describes the observed (real-world) electromagnetic response of an electromagnetic element. The experimentally measured data may be obtained by any conventional measurement apparatus, and the comparison may be performed using known techniques, e.g. based on obtaining numerical parameters indicative of a difference between the electromagnetic response obtained in step 1104 and the experimentally measured data.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

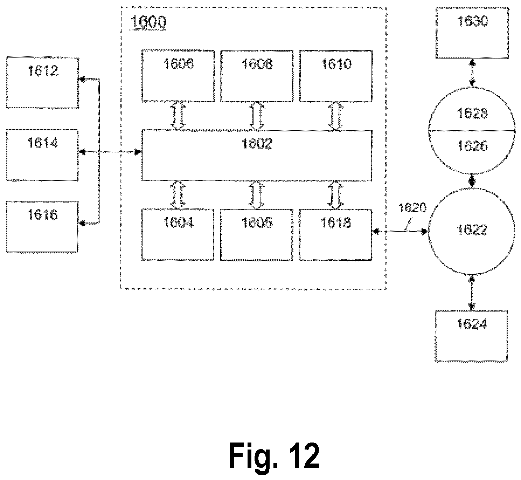

Figure 12 is a block diagram that illustrates a computer system 1600 that may assist in implementing the methods and flows disclosed herein. Computer system 1600 includes a bus 1602 or other communication mechanism for communicating information, and a processor 1604 (or multiple processors 1604 and 1605) coupled with bus 1602 for processing information. Computer system 1600 also includes a main memory 1606, such as a random access memory (RAM) or other dynamic storage device, coupled to bus 1602 for storing information and instructions to be executed by processor 1604. Main memory 1606 also may be used for storing temporary variables or other intermediate information during execution of instructions to be executed by processor 1604. Computer system 1600 further includes a read only memory (ROM) 1608 or other static storage device coupled to bus 1602 for storing static information and instructions for processor 1604. A storage device 1610, such as a magnetic disk or optical disk, is provided and coupled to bus 1602 for storing information and instructions.

Computer system 1600 may be coupled via bus 1602 to a display 1612, such as a cathode ray tube (CRT) or flat panel or touch panel display for displaying information to a computer user. An input device 1614, including alphanumeric and other keys, is coupled to bus 1602 for communicating information and command selections to processor 1604. Another type of user input device is cursor control 1616, such as a mouse, a trackball, or cursor direction keys for communicating direction information and command selections to processor 1604 and for controlling cursor movement on display 1612. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1600 in response to processor 1604 executing one or more sequences of one or more instructions contained in main memory 1606. Such instructions may be read into main memory 1606 from another computer-readable medium, such as storage device 1610. Execution of the sequences of instructions contained in main memory 1606 causes processor 1604 to perform the process steps described herein. One or more processors in a multi-processing arrangement may also be employed to execute the sequences of instructions contained in main memory 1606. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1604 for execution. Such a medium may take many forms, including but not limited to, non-volatile media, volatile media, and transmission media. Non-volatile media include, for example, optical or magnetic disks, such as storage device 1610. Volatile media include dynamic memory, such as main memory 1606. Transmission media include coaxial cables, copper wire and fiber optics, including the wires that comprise bus 1602. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1604 for execution. For example, the instructions may initially be borne on a magnetic disk of a remote computer. The remote computer can load the instructions into its dynamic memory and send the instructions over a telephone line using a modem. A modem local to computer system 1600 can receive the data on the telephone line and use an infrared transmitter to convert the data to an infrared signal. An infrared detector coupled to bus 1602 can receive the data carried in the infrared signal and place the data on bus 1602. Bus 1602 carries the data to main memory 1606, from which processor 1604 retrieves and executes the instructions. The instructions received by main memory 1606 may optionally be stored on storage device 1610 either before or after execution by processor 1604.

Computer system 1600 also preferably includes a communication interface 1618 coupled to bus 1602. Communication interface 1618 provides a two-way data communication coupling to a network link 1620 that is connected to a local network 1622. For example, communication interface 1618 may be an integrated services digital network (ISDN) card or a modem to provide a data communication connection to a corresponding type of telephone line. As another example, communication interface 1618 may be a local area network (LAN) card to provide a data communication connection to a compatible LAN. Wireless links may also be implemented. In any such implementation, communication interface 1618 sends and receives electrical, electromagnetic or optical signals that carry digital data streams representing various types of information.

Network link 1620 typically provides data communication through one or more networks to other data devices. For example, network link 1620 may provide a connection through local network 1622 to a host computer 1624 or to data equipment operated by an Internet Service Provider (ISP) 1626. ISP 1626 in turn provides data communication services through the worldwide packet data communication network, now commonly referred to as the "Internet" 1628. Local network 1622 and Internet 1628 both use electrical, electromagnetic or optical signals that carry digital data streams. The signals through the various networks and the signals on network link 1620 and through communication interface 1618, which carry the digital data to and from computer system 1600, are exemplary forms of carrier waves transporting the information.

Computer system 1600 may send messages and receive data, including program code, through the network(s), network link 1620, and communication interface 1618. In the Internet example, a server 1630 might transmit a requested code for an application program through Internet 1628, ISP 1626, local network 1622 and communication interface 1618. One such downloaded application may provide for one or more of the techniques described herein, for example. The received code may be executed by processor 1604 as it is received, and/or stored in storage device 1610, or other non-volatile storage for later execution. In this manner, computer system 1600 may obtain application code in the form of a carrier wave.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

An embodiment may include a method of computing Fourier coefficient for calculating electromagnetic scattering properties of a structure, wherein at least part of the structure is represented by a polygon, the method comprising: A first step of computing a first part of the Fourier coefficient, wherein the first part is a function of number of edges of the polygon, and a second step of computing a second part of the Fourier coefficient, wherein the second part is a function of number of Fourier models. Optionally, the first part is a function of number of sample points per edge. Optionally, the first part is not dependent on the number of Fourier models. Optionally, the second part is not dependent on the number of edges of the polygon and/or the number of sample points per edge.

Further embodiments are disclosed in the subsequent numbered clauses:

Clause 1: A computer-implemented method for generating a spectral model representation of an electromagnetic element in an electromagnetic system for use in determining an electromagnetic response to electromagnetic radiation interacting with said electromagnetic element, the representation comprising a two-dimensional array of elements corresponding to respective wave vectors, the wave vectors being defined by corresponding wave numbers in each of first and second mutually transverse directions, wherein said electromagnetic element is described geometrically as a plurality of slices stacked transverse to the first and second transverse directions, each slice containing one or more polygons, the method comprising: for each polygon in the one or more polygons: determining a respective plurality of points, the points including points along each edge of the polygon; for each of said plurality of points: computing respective first and second coefficients based on an extent of the corresponding polygon edge in each of the first and second mutually transverse directions, respectively; generating a first Fourier component for each of the wave vectors by performing a Fast Fourier Transform, FFT, algorithm based on the plurality of points, and for each point using the respective first coefficient; generating a second Fourier component for each of said wave vectors by performing a Fast Fourier Transform, FFT, algorithm based on the plurality of points, and for each point using the respective second coefficient; generating the array of elements based on the first and second Fourier components for each polygon.

Clause 2: A method according to clause 1, wherein the points, along each polygon edge, are non-uniformly distributed along said edge.

Clause 3: A method according to clause 1, wherein the points, along each polygon edge, are uniformly distributed along said edge.

Clause 4: A method according to any one of clauses 1 to 2, wherein the FFT is a non-uniform FFT.

Clause 5: A method according to any one of clauses 1 to 4, wherein each step of computing respective first and second coefficients is further based on a respective quadrature weight from a numerical quadrature rule, wherein each of said quadrature weights is associated with a respective quadrature point that corresponds with one of the plurality of points along the polygon edges.

Clause 6: A method according to clause 5, wherein each of said quadrature weights and the respective quadrature point is determined by scaling a corresponding quadrature weight and quadrature weight from a lookup table according to a length of the polygon edge to which said quadrature point relates.

Clause 7: A method according to clause 6, wherein said step of determining a respective plurality of points includes: mapping the quadrature points for each polygon edge onto that respective polygon edge.

Clause 8: A method according to any one of clauses 5 to 7, wherein the numerical quadrature rule is the Gauss-Legendre quadrature rule.

Clause 9: A method according to any one of the preceding clauses, further comprising: partitioning a polygon edge, conditional upon the product of the number of wavenumbers in each of (a) the first and (b) second mutually transverse directions being greater than the number of points along that respective polygon edge, until said product is less than said number of points.

Clause 10: A method according to any one of the preceding clauses, wherein the number of edges in any one of the one or more polygons is greater than 50, more preferably greater than 250, even more preferably greater than 500.

Clause 11: A method according to any one of the preceding clauses, wherein, for any one of the one or more polygons, the number of the points along any one of the polygon edges is less than 400, more preferably less than 150, even more preferably less than 50.

Clause 12: A method according to any one of the preceding clauses, wherein the number of wave numbers in each of the first and second mutually transverse directions is greater than 25, more preferably greater than 50, even more preferably greater than 100.

Clause 13: A method according to any one of clauses 1 to 9, wherein, for any one of the polygons, the maximum product of: (i) the number of edges of said polygon; (ii) the number of points along each polygon edge of said polygon; and (iii) the number of wavenumbers in each of the first and second mutually transverse direction, is greater than 60,000, more preferably greater than 1,850,000, even more preferably greater than 20,000,000.

Clause 14: A method according to any one of clauses 5 to 13, further comprising: deriving the number of quadrature points required for each polygon edge according to a predefined upper bound for the error, when using the numerical quadrature rule; and said determining a respective plurality of points for each polygon including determining the derived number of points along each edge of the polygon.

Clause 15: A computer program product comprising instructions, which, when executed by a computer processor, causes the computer processor to perform the method steps of any one of clauses 1 to 14.

Clause 16: A computer system, comprising one or more processors configured to perform the method of any one of clauses 1 to 14.

Clause 17: A computer-implemented method for determining an electromagnetic response to electromagnetic radiation interacting with said electromagnetic element, said method comprising: inputting a spectral model representation for the electromagnetic element obtained from any one of method clauses 1 to 14 into Maxwell solver.

Clause 18: A method according to clause 17, wherein the electromagnetic radiation is in the soft X-ray band.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A computer-implemented method for generating a spectral model representation of an electromagnetic element in an electromagnetic system for use in determining an electromagnetic response to electromagnetic radiation interacting with said electromagnetic element, the representation comprising a two-dimensional array of elements corresponding to respective wave vectors, the wave vectors being defined by corresponding wave numbers in each of first and second mutually transverse directions, wherein said electromagnetic element is described geometrically as a plurality of slices stacked transverse to the first and second transverse directions, each slice containing one or more polygons, the method comprising:

   for each polygon in the one or more polygons:

   determining a respective plurality of points, the points including points along each edge of the polygon;
   for each of said plurality of points:

   computing respective first and second coefficients based on an extent of the corresponding polygon edge in each of the first and second mutually transverse directions, respectively;
   generating a first Fourier component for each of the wave vectors by performing a Fast Fourier Transform, FFT, algorithm based on the plurality of points, and for each point using the respective first coefficient;
   generating a second Fourier component for each of said wave vectors by performing a Fast Fourier Transform, FFT, algorithm based on the plurality of points, and for each point using the respective second coefficient;

   generating the array of elements based on the first and second Fourier components for each polygon.

2. A method according to claim 1, wherein the points, along each polygon edge, are non-uniformly distributed along said edge.

3. A method according to claim 1, wherein the points, along each polygon edge, are uniformly distributed along said edge.

4. A method according to any one of claims 1 to 2, wherein the FFT is a non-uniform FFT.

5. A method according to any one of claims 1 to 4, wherein each step of computing respective first and second coefficients is further based on a respective quadrature weight from a numerical quadrature rule, wherein each of said quadrature weights is associated with a respective quadrature point that corresponds with one of the plurality of points along the polygon edges.

6. A method according to any one of the preceding claims, further comprising:
partitioning a polygon edge, conditional upon the product of the number of wavenumbers in each of (a) the first and (b) second mutually transverse directions being greater than the number of points along that respective polygon edge, until said product is less than said number of points.

7. A method according to any one of the preceding claims, wherein the number of edges in any one of the one or more polygons is greater than 50, more preferably greater than 250, even more preferably greater than 500.

8. A method according to any one of the preceding claims, wherein, for any one of the one or more polygons, the number of the points along any one of the polygon edges is less than 400, more preferably less than 150, even more preferably less than 50.

9. A method according to any one of the preceding claims, wherein the number of wave numbers in each of the first and second mutually transverse directions is greater than 25, more preferably greater than 50, even more preferably greater than 100.

10. A method according to any one of claims 1 to 6, wherein, for any one of the polygons, a product of the number of wavenumbers in each of the first and second mutually transverse direction is greater than a number of points along any one of the polygon edges.

11. A method according to any one of claims 5 to 10, further comprising:

deriving the number of quadrature points required for each polygon edge according to a predefined upper bound for the error, when using the numerical quadrature rule; and
said determining a respective plurality of points for each polygon including determining the derived number of points along each edge of the polygon.

12. A computer program product comprising instructions, which, when executed by a computer processor, causes the computer processor to perform the method steps of any one of claims 1 to 11.

13. A computer system, comprising one or more processors configured to perform the method of any one of claims 1 to 11.

14. A computer-implemented method for determining an electromagnetic response to electromagnetic radiation interacting with said electromagnetic element, said method comprising:
inputting a spectral model representation for the electromagnetic element obtained from any one of method claims 1 to 11 into a Maxwell solver.

15. A method of characterizing an electromagnetic element comprising: comparing a measured electromagnetic response with an electromagnetic response determined according to claim 14.

# Fig. 1

# Fig. 2

# Fig. 3

**Fig. 4**

**Fig. 5**

Fig. 6

Fig. 7

800

805

806

803

A ----------------------------------- A'

802

804

801

# Fig. 8A

800

808

806

# Fig. 8B

900

Fig. 9

1002

Determining a plurality of points, for each polygon

1004

Computing first and second coefficients, for each point in the plurality of points, based on an extension of the corresponding polygon edge in each of the first and second transverse directions, respectively

1006

Generating first Fourier components, for each polygon and for a plurality of wave vectors, by performing a FFT algorithm based on the respective plurality of points and respective first coefficients

1008

Generating second Fourier components, for each polygon and for a plurality of wave vectors, by performing a FFT algorithm based on the respective plurality of points and respective second coefficients

1010

Generating the spectral representation of the electromagnetic element based on the first and second Fourier components for each polygon

Fig. 10

**1102**

Generating a spectral model representation of an electromagnetic element

**1104**

Inputting the spectral model representation for the electromagnetic element into a Maxwell solver

Fig. 11

Fig. 12

**EUROPEAN SEARCH REPORT**

Europäisches Patentamt
European Patent Office
Office européen des brevets

Application Number

EP 23 20 0829

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PORTER CHRISTINA ET AL: "Soft x-ray: novel metrology for 3D profilometry and device pitch overlay", 20230427, vol. 12496, 27 April 2023 (2023-04-27), pages 124961I-124961I, XP060180049, ISSN: 0277-786X, DOI: 10.1117/12.2658495 ISBN: 978-1-5106-6099-1 | 1-14 | INV. G03F7/00 |
| A | * abstract * * section 4; figure 6 * | 15 | |
| X | WO 2017/012840 A1 (ASML NETHERLANDS BV [NL]) 26 January 2017 (2017-01-26) | 1-14 | |
| A | * paragraphs [0048] – [0072]; figures 5-10 * | 15 | |
| X | US 9 915 522 B1 (JIANG PEILIN [US] ET AL) 13 March 2018 (2018-03-13) | 1-14 | |
| A | * column 5, line 3 – column 18, line 31; figures 2, 3A– 3D * | 15 | TECHNICAL FIELDS SEARCHED (IPC) |
| | | | G03F |

The present search report has been drawn up for all claims

| Place of search | Date of completion of the search | Examiner |
|---|---|---|
| Munich | 22 March 2024 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 0829

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2024

| Patent document cited in search report | | | Publication date | Patent family member(s) | | | Publication date |
|---|---|---|---|---|---|---|---|
| WO 2017012840 | A1 | | 26-01-2017 | CN | 107924142 | A | 17-04-2018 |
| | | | | IL | 256753 | A | 29-03-2018 |
| | | | | IL | 280148 | A | 01-03-2021 |
| | | | | JP | 6810734 | B2 | 06-01-2021 |
| | | | | JP | 2018522279 | A | 09-08-2018 |
| | | | | KR | 20180030162 | A | 21-03-2018 |
| | | | | NL | 2017074 | A | 19-01-2017 |
| | | | | TW | 201712437 | A | 01-04-2017 |
| | | | | US | 2017017738 | A1 | 19-01-2017 |
| | | | | US | 2020202054 | A1 | 25-06-2020 |
| | | | | WO | 2017012840 | A1 | 26-01-2017 |
| US 9915522 | B1 | | 13-03-2018 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1

### Non-patent literature cited in the description

- *Proc. SPIE 12496, Metrology, Inspection, and Process Control*, vol. XXXVII
- **LEMAILLET et al.** Intercomparison between optical and X-ray scatterometry measurements of FinFET structures. *Proc. of SPIE*, 2013, 8681